(19) Europäisches Patentamt
European Patent Office
Office européen des brevets

(11) EP 2 192 415 A1

(12) EUROPEAN PATENT APPLICATION
published in accordance with Art. 153(4) EPC

(43) Date of publication:
02.06.2010 Bulletin 2010/22

(51) Int Cl.:
G01R 23/16 (2006.01)          G01R 23/00 (2006.01)
G06F 17/14 (2006.01)

(21) Application number: 08832622.8

(22) Date of filing: 17.09.2008

(86) International application number:
PCT/JP2008/066689

(87) International publication number:
WO 2009/038056 (26.03.2009 Gazette 2009/13)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 20.09.2007 JP 2007243858

(71) Applicant: National University Corporation
University Of Toyama
Toyama-shi, Toyama 930-8555 (JP)

(72) Inventor: HIROBAYASHI, Shigeki
Toyama-shi
Toyama 930-8555 (JP)

(74) Representative: Grebner, Christian Georg Rudolf
Patentanwälte
Seemann & Partner
Ballindamm 3
20095 Hamburg (DE)

(54) SIGNAL ANALYSIS METHOD, SIGNAL ANALYSIS DEVICE, AND SIGNAL ANALYSIS PROGRAM

(57) Provided is a signal analysis device that has a high frequency resolution not depending on an analysis window length and can analyze a frequency with considerably high accuracy. When the signal analysis device inputs therein an analysis object signal to be analyzed, the device obtains a frequency $f'$, amplitude $A'$ and an initial phase $\varphi'$ such that the sum of squares of a difference between the analysis object signal and a sinusoidal model signal expressed by a phase using the frequency $f'$ and the initial phase $\varphi'$ and by the amplitude $A'$ is a minimum value.

**FIG. 2**

**Description**

Technical Field:

The present invention relates to a signal analysis method, a signal analysis device and a signal analysis program, all for analyzing the frequency of a signal to be input.

Background Art:

The frequency of an input signal has heretofore been analyzed in various fields including a signal measurement field, a digital signal compression-coding field and a field of future prediction of economic time series signal perturbation. As a signal analysis method using a so-called sinusoidal model, as also introduced in Non-Patent Document 1, various techniques have been proposed. The majority thereof, however, comprises estimating in advance the frequency of a signal and obtaining optimal amplitude and an initial phase in the estimated frequency.

A signal comprises superposed sine waves having a plurality of frequencies and, in order to analyze the signal, it is necessary to estimate frequency parameters including amplitude and an initial phase of each of the sine waves having various frequencies constituting the signal. As such a frequency analysis technique, the Fourier transform has widely been known. When estimating the frequency parameters in the Fourier transform, it is possible to use the Fourier transform formula by a finite-length window, as shown in Formula (1) below, in the case of a periodic signal and, based on Formula (1), parameters (amplitude $A$ and an initial phase $\varphi$) of a specific frequency $f\,(=n/T$, in which n denotes an integer and $T$ an analysis window length) can be estimated, provided that the relationship among the amplitude $A$, initial phase $\varphi$ and $X(f)$ is as shown in Formula (2) below.

## [Mathematical Formula 1]

$$X(f) = \int_0^T x(t)e^{-j2\pi ft}dt \qquad \cdots (1)$$

## [Mathematical Formula 2]

$$X(f) = \frac{A}{2}e^{j\phi} \qquad \cdots (2)$$

The frequency parameters capable of being estimated by the Fourier transform depend on the analysis window length $T$, and the number of frequencies corresponding to the integral multiple of $1/T$ can only be calculated. Insofar as the parameters are estimated using Formula (1) above, therefore, the frequency $f$ becomes discrete in principle and it is impossible to specify frequency components of a nonperiodic signal. In addition, in spite of the fact that a nonperiodic signal having no period is to be analyzed in major fields performing the frequency analysis using the Fourier transform, since the integration calculation over the integral interval of indefinite length is extremely difficult to perform, it is as affairs now stand that Formula (1) has to be used.

In order to solve the problem, it has been tried to enhance an apparent frequency resolution utilizing the adjustment of a window function and plural analysis intervals.

The Short-Time Fourier Transform or Short-Term Fourier Transform (STFT) described in Non-Patent Document 2, for example is means comprising dividing an acoustic into plural signals using the short-time analysis window and subjecting the individual signals to the Fourier transform independently.

In addition, in the ABS (Analysis by Synthesis) method or GHA (Generalized Harmonic Analysis described in Non-Patent Document 3 to Non-Patent Document 6, plural frequencies for determining an optimal frequency are prepared to obtain amplitude and an initial phase, and a combination of the optimal frequency, amplitude and initial phase is selected from them.

Non-Patent Document 1: Mikio Tohyama and Tsunehiko Koike, "Signal Analysis Means with High Frequency Analysis Accuracy", Journal of the Acoustical Science of Japan, Vol. 54, No. 8, 1988

Non-Patent Document 2: L. R. Rabiner and R. W. Schafer, "Digital Processing of Speech Signals", Prentice-Hall, Engiewood Cliffs, NJ, 1978

Non-Patent Document 3: T. F. Quatieri and R. J. McAullay, "Speech transformations based on a sinusoidal representation", IEEE Trans. Acoust. Speech Signal Process, ASSP 34, 1986, pp. 1449-1464

Non-Patent Document 4: E. B. George and M. J. Smith, "Analysis-by-synthesis/overlap-add sinusoidal representations", J. Audio Eng. Soc. 40, 1992, pp. 497-515

Non-Patent Document 5: E. B. George and M. J. Smith, "Speech analysis/synthesis and modification using analysis-by-synthesis/overlap-add sinusoidal model", IEEE Trans. Speech Audio Process, 5, 1997, pp. 389-406

Non-Patent Document 6: T. Terada, H. Nakajima, M. Tohyama and Y. Hirata, "Non-stationary wafeform analysis and synthesis using generalized harmonic analysis", IEEE-SP, Int. Symp. TF/TS Analysis, 1994, pp. 429-432

The short-time Fourier transform described in Non-Patent Document 2, however, still entails a problem that the frequency parameters can be estimated only in the case of using an integral multiple of the inverse number of the short-time analysis window length.

In addition, in the ABS method or GHA described in Non-Patent Document 3 to Non-Patent Document 6, when the original signal has a frequency different from the frequencies prepared in advice, plural erroneous combinations are detected to entail a problem that the analysis accuracy is lowered.

In trying to enhance an apparent frequency resolution utilizing the adjustment of the window function and plural analysis intervals, the problems indicated are:

1) to make it difficult to perceive temporal frequency fluctuation because the frequencies of signals involving the temporal fluctuation are averaged while the analysis length is made long in order to heighten a frequency resolution and
2) to lower the frequency resolution in the meantime when the analysis window length is made short.

Thus, the relationship between perceiving the frequency variation in detail and enhancing the frequency resolution that are mutually conflicting poses a serious problem from the standpoint of the signal analysis.

Disclosure of the Invention:

The present invention has been accomplished in view of these circumstances, and the object thereof is to provide a signal analysis method, a signal analysis device and a signal analysis program, each of which exhibits a high frequency resolution not depending on an analysis window length and is capable of analyzing a frequency with considerably high accuracy.

The signal analysis method according to the present invention capable of attaining the above object is for analyzing the frequency of a signal to be input and comprises a signal-inputting step of inputting into a signal analysis device an analysis object signal to be analyzed and storing the input signal in a memory, a parameter-calculating step of retrieving with calculation means of the signal analysis device the analysis object signal input and stored in the memory at the signal-inputting step and obtaining a frequency $f$, amplitude $A'$ and an initial phase $\varphi'$ such that a sum of squares of a difference between the analysis object signal and a sinusoidal model signal expressed by a phase using the frequency $f$ and the initial phase $\varphi'$ and by the amplitude $A'$ is a minimum value, and an analysis result-outputting step of outputting to analysis result-outputting means analysis results based on the frequency $f$, amplitude $A'$ and initial phase $\varphi'$ obtained at the parameter-calculating step.

In addition, the signal analysis device according to the present invention capable of attaining the above object is for analyzing the frequency of a signal to be input and comprises signal-inputting means for inputting an analysis object signal to be analyzed, parameter-calculating means for obtaining a frequency $f$, amplitude $A'$ and an initial phase $\varphi'$ such that a sum of squares of a difference between the analysis object signal input via the signal-inputting means and a sinusoidal model signal expressed by a phase using the frequency $f$ and the initial phase $\varphi'$ and by the amplitude $A'$ is a minimum value, and analysis result-outputting means for outputting analysis results based on the frequency $f$, amplitude $A'$ and initial phase $\varphi'$ obtained with the parameter-calculating means.

Furthermore, the signal analysis program according to the present invention capable of attaining the above object is for executing a computer for analyzing the frequency of a signal to be input and allows the computer to function as signal-inputting means for inputting an analysis object signal to be analyzed, as parameter-calculating means for obtaining a frequency $f$, amplitude $A'$ and an initial phase $\varphi'$ such that a sum of squares of a difference between the analysis object signal input via the signal-inputting means and a sinusoidal model signal expressed by a phase using the frequency $f$ and the initial phase $\varphi'$ and by the amplitude $A'$ is a minimum value; and as analysis result-outputting means for outputting analysis results based on the frequency $f$, amplitude $A'$ and initial phase $\varphi'$ obtained with the parameter-calculating means.

The signal analysis method, the signal analysis device and a device having the signal analysis program mounted therein according to the present invention can realize a new frequency analysis technique, in which a frequency resolution does not depend on an analysis window length, through the formulation of a nonperiodic signal with the aim of an assumed frequency analysis and the substitution of a subject of seeking an optimum solution to a nonlinear equation for a subject of obtaining parameters of a nonperiodic signal by the Fourier transform.

The present invention exhibits a high frequency resolution without being subjected to restraints of an analysis window length and a frequency resolution and can analyze a frequency with considerably higher accuracy by not less than hundred thousands to ten billions than the accuracies of conventional frequency analysis techniques.

Brief Description of the Drawings:

Figure 1 is a block diagram showing the configuration of a signal analysis device according to an embodiment of the present invention.

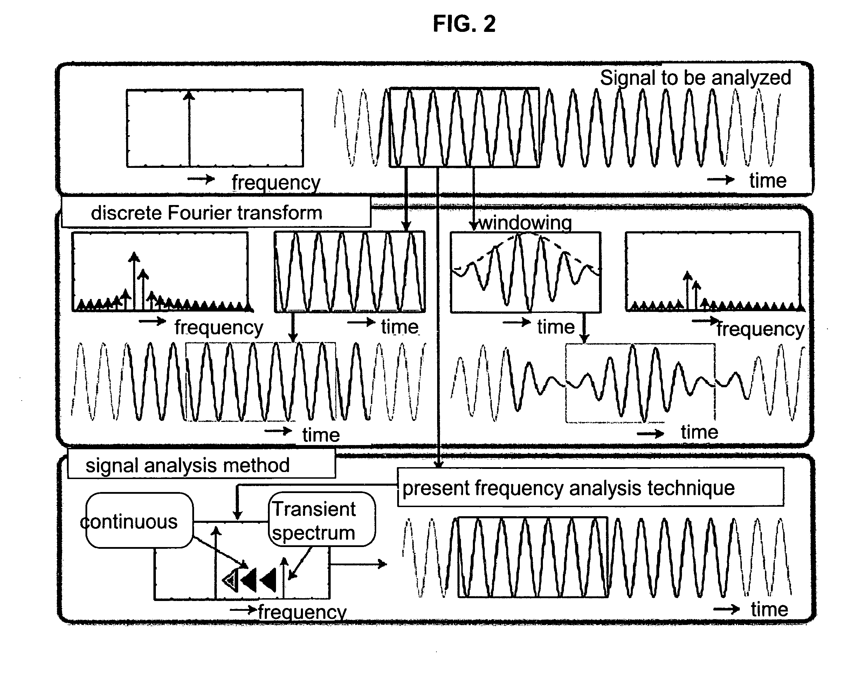

Figure 2 is a diagram for illustrating the difference between frequency analysis means of the present invention and DFT.

Figure 3 is a diagram for illustrating the difference between the frequency analysis means of the present invention and DFT and showing a concrete example in which each means is applied to a two-dimensional signal to be analyzed.

Figure 4 is a diagram for illustrating the differences among the frequency analysis means of the present invention, DFT and GHA and showing the results of errors obtained in each means.

Figure 5 is a diagram showing a concrete example of the sound of a piano that is a signal to be analyzed.

Figure 6(A) is a diagram showing the spectrogram obtained through the analysis of the signal shown in Figure 5 using the DFT.

Figure 6(B) is a diagram showing the spectrogram obtained through the analysis of the signal shown in Figure 5 using the frequency analysis means of the present invention.

Figure 7 is a diagram for illustrating the difference between the frequency analysis means of the present invention and the DFT and showing a concrete example of the analysis accuracy of spectra obtained by applying each means to a two-dimensional signal to be analyzed.

Figure 8 is a diagram for illustrating the differences among the frequency analysis means of the present invention, JPEG and JPEG 2000 and showing a concrete example in which two-dimensional bitmapped image data have been compressed.

Figure 9 is a diagram showing a prediction example of the economic figures to which the frequency analysis means of the present invention has been applied.

Figure 10 is a diagram showing the difference in error between the actual data and the prediction data obtained by the application of the frequency analysis technique of the present invention.

Best Mode for carrying out the Invention:

A concrete embodiment to which the present invention is applied will be described in detail with reference to the drawings.

This embodiment relates to a signal analysis device for analyzing an input signal. Particularly, this signal analysis device realizes a new frequency analysis technique, in which a frequency resolution does not depend on an analysis window length, through solving a nonlinear equation to estimate a Fourier coefficient.

[Configuration of Signal Analysis Device]

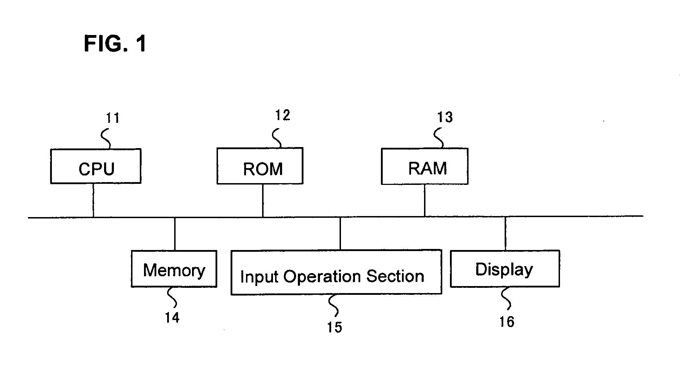

The signal analysis device comprises a computer, for example and is, as shown in Figure 1, equipped with a CPU (Central Processing Unit) 11 for controlling each section in an across-the-board fashion, a ROM (Read Only Memory) 12 for storing various data including various programs, a RAM (Random Access Memory) 13 functioning as a work area, a memory section 14 for storing various data so as to be readable and/or writable, an input operation control section 15 for processing and controlling an input operation taken via an unshown prescribed operation device serving as a user interface, and a display section 16 for displaying various data.

The CPU 11 executes various programs, including various application programs, stored in the memory section 14 and controls each section in an across-the-board fashion.

The ROM 12 stores various date including various programs. The data stored in this ROM 12 are read under the control of the CPU 11.

The RAM 13 serves as a work area when the CPU 11 executes various programs, and temporarily stores various data and reads the stored various data under the control of the CPU 11.

The memory section 14 stores various data including data of analysis object signals, the frequencies of which are to be analyzed, besides application programs including signal analysis programs according to the present invention. A hard disc or nonvolatile memory, for example, can be used as the memory section 14. In addition, the memory section 14 includes a drive device performing read and/or write of various data relative to a memory medium, such as a flexible disc or memory card detachably attached to a main body. The various data stored in the memory section 14 are read under the control of the CPU 11.

The input operation section 15 receives input operations taken via an unshown prescribed operation device serving as a user interface, such as a keyboard, a mouse, a keypad, an infrared remote controller, a stick key or a push button, and supplies control signals showing operation contents to the CPU 11.

As the display section 16, various display devices including a liquid crystal display (LCD), a plasma display panel (PDP), an organic electroluminescent display and a CRT (Cathode Ray Tube) can be used. The display section displays various data under the control of CPU 11. When the CPU 11 has initiated a signal analysis program, for example, the display section 16 displays the screen thereof on which the input analysis object signals or frequency analysis results are displayed.

The signal analysis device equipped with these sections, when executing the signal analysis program under the control of the CPU 11, analyzes the frequency of the input signal under the control of the CPU 11. Incidentally, the signal, the frequency of which is to be analyzed, i.e. the aforementioned analysis object signal, is input via an unshown signal input section and stored in the memory section 14 so as to be readable by means of the CPU 11. In the case of a time series signal measured by an arbitrary sensor being the analysis object signal, for example, the signal analysis device inputs the time series signal serving as the analysis object signal by storing it in the memory section 14 via a prescribed interface that connects the signal analysis device and the sensor. In addition, the signal analysis device has a function to perform compression coding of image data imaged by an imaging device, such as a digital camera, and when analyzing the frequency at the time of the compression coding, inputs the time series signal serving as the analysis object signal by storing it in the memory section 14 via a prescribed interface that connects the signal analysis device and the imaging device. Furthermore, the signal analysis device, when used for estimating future stock price movements etc., inputs previous stock price data serving as analysis object signals by storing these in the memory section 14 via the Internet. Otherwise, the signal analysis device may input arbitrary data a user has created as the analysis object signals by storing these in the memory section 14. That is to say, the signal input section is a section having a function to input the analysis object signal so as to be readable by the CPU 11. Incidentally, it goes without saying that the signal input section also has a function to perform A/D conversion when an analog signal has been input and convert the analog signal into a digital signal. In this case, the signal input section may be an A/D converter including an anti-aliasing filter, as occasion demands. The signal analysis device analyzes the frequency of the analysis object signal thus input, under the control of the CPU 11, and displays on and outputs to the display section 16 the analyzed results via an unshown analysis result output section or outputs the same to a printer or other equipment.

[Frequency Analysis Algorithm]

A frequency analysis algorithm in the signal analysis device will be described hereinafter in detail.

A frequency analysis technique applied to the signal analysis device, i.e. a frequency analysis technique proposed newly in the present invention (hereinafter referred to as the "present frequency analysis technique), focuses attention on a subject of seeking a solution to a nonlinear equation in order to essentially solving the problem of the conventional frequency analysis technique that exhibits "the relationship between perceiving the frequency variation in detail and enhancing the frequency resolution that are mutually conflicting". That is to say, in the present frequency analysis technique, the subject of seeking an optimum solution to the nonlinear equation has been substituted for the subject of obtaining the frequency parameters of a nonperiodic signal through a Fourier transform formula shown by Formula 3 below.

## [Mathematical Formula 3]

$$X(f) = \int_{-\infty}^{\infty} x(t)e^{-j2\pi ft}dt \qquad \cdots (3)$$

To be specific, in present frequency analysis technique, as an optimal solution to a nonlinear equation expressed by the sum of squares of a difference between an analysis object signal $x(n)$ and a sinusoidal model signal, as shown in Formula(4) below, a frequency $f$, amplitude $A'$ and an initial phase $\varphi'$ satisfying that the right-hand side of the nonlinear equation becomes minimum are obtained. Incidentally, in Formula (4) below, $L$ denotes a frame length (analysis window length) and $f_s$ a sampling frequency [Hz]. There is no case where the frequency $f$ is added as a parameter to a nonlinear equation, and this addition is way-out. In other words, in the present frequency analysis technique, a method of solution to the nonlinear equation relative to Formula (3) above is used with the aim of accurately obtaining not only the amplitude $A'$ and initial phase $\varphi'$, but also the frequency $f$. In the present frequency analysis technique, by boiling down to the question of obtaining the optimal solution to the nonlinear equation using the least-square method, a flexible frequency analysis processing can be realized, with one period or more of the analysis window length, an integral multiple of the period and further existence of an unequal space allowed, without bringing about influences of the analysis window and aliasing.
## [Mathematical Formula 4]

$$F(A', f', \phi') = \frac{1}{L}\sum_{n=0}^{L-1}\left\{x(n) - A'\cos(2\pi f'\frac{n}{f_s} + \phi')\right\}^2 \qquad \cdots (4)$$

Incidentally, though Formula (4) above assumes the case where the analysis object signal $x(n)$ is a one-dimensional signal, such as a time series signal measured with a sensor, the present frequency analysis technique is applicable to two-dimensional signals including two-dimensional image data, three-dimensional signals including dynamic picture image data, four-dimensional signals including solid dynamic picture image data and higher-dimensional signals. That is to say, when the first-dimensional, second-dimensional, three-dimensional and four-dimensional analysis object signals has been generalized as $s(x_n)$, $s(x_m, y_n)$, $s(x_l, y_m, z_n)$ and $s(x_k, y_l, z_m, w_n)$, respectively, the present frequency analysis technique is adapted to seek optimal solutions to nonlinear equations shown in Formulae (5) to (8) in the respective cases of the first-dimensional, second-dimensional, three-dimensional and four-dimensional analysis object signals.
## [Mathematical Formula 5]

$$F(A', f_x', \phi') = \frac{1}{N}\sum_{n=1}^{N}\left\{s(x_n) - A'\cos(2\pi f_x' x_n + \phi')\right\}^2 \qquad \cdots (5)$$

## [Mathematical Formula 6]

$$F(A', f_x', f_y', \phi') = \frac{1}{MN} \sum_{m=1}^{M} \sum_{n=1}^{N} \left\{ s(x_m, y_n) - A'\cos(2\pi f_x' x_m + 2\pi f_y' y_n + \phi') \right\}^2$$

$$\cdots (6)$$

## [Mathematical Formula 7]

$$F(A', f_x', f_y', f_z', \phi') = \frac{1}{LMN} \sum_{l=1}^{L} \sum_{m=1}^{M} \sum_{n=1}^{N} \left\{ s(x_l, y_m, z_n) - A'\cos(2\pi f_x' x_l + 2\pi f_y' y_m + 2\pi f_z' z_n + \phi') \right\}^2$$

$$\cdots (7)$$

## [Mathematical Formula 8]

$$F(A', f_x', f_y', f_z', f_w', \phi')$$
$$= \frac{1}{KLMN} \sum_{k=0}^{K-1} \sum_{l=0}^{L-1} \sum_{m=0}^{M-1} \sum_{n=0}^{N-1} \left\{ s(x_k, y_l, z_m, w_n) - A'\cos(2\pi f_x' x_k + 2\pi f_y' y_l + 2\pi f_z' z_m + 2\pi f_w' w_n + \phi') \right\}^2$$

$$\cdots (8)$$

In other words, the present frequency analysis technique is adapted to seek an optimal solution to a nonlinear equation shown by Formula (9) below when an arbitrary $n$-dimensional ($n$ denoting an integer of 1 or more) analysis object signal has been generalized as $s(x1_{n1}, x2_{n2}, x3_{n3}, ..., xn_{nn})$.

## [Mathematical Formula 9]

$$F(A', f_{x1}', f_{x2}', f_{x3}', \cdots, f_{xn}', \phi')$$
$$= \frac{1}{N1 \bullet N2 \bullet N3 \bullet \cdots \bullet NN}$$
$$\sum_{n1=0}^{N1-1} \sum_{n2=0}^{N2-1} \sum_{n3=0}^{N3-1} \cdots \sum_{nn=0}^{NN-1} \left\{ s(x1_{n1}, x2_{n2}, x3_{n3}, \cdots, xn_{nn}) - A'\cos(2\pi f_{x1}' x1_{n1} + 2\pi f_{x2}' x2_{n2} + 2\pi f_{x3}' x3_{n3} + \cdots + 2\pi f_{xn}' xn_{nn} + \phi') \right\}$$

$$\cdots (9)$$

Incidentally, for the sake of convenience, the following description is made, with an analysis object signal regarded as a one-dimensional signal, for seeking an optimal solution to the nonlinear equation shown by Formula (4) above.

Well, in actually seeking the optimal solution to the nonlinear equation shown by Formula 4 above, the following methods can be adopted.

In the present frequency analysis technique, appropriate initial values of the amplitude $A'$, frequency $f'$ and initial phase $\phi'$ are respectively obtained and are subjected to convergence on optimal solutions using the method of solution to the nonlinear equation. The nonlinear problem is regarded as the minimization problem, with Formula (4) above as a cost function. Incidentally, the optimal initial values can be obtained by applying an existing arbitrary method, such as by being subjected to arbitrary frequency transform including discrete Fourier transform (hereinafter referred to as the "DFT") or wavelet transform or by performing filtering to come up with some kinds of ideas of the optimal initial values.

At first, in the present frequency analysis technique, a so-called steepest descent method is applied to the frequency parameters $f'$ and $\varphi'$ constituting the phase of the sinusoidal model signal in the Formula (4) above, thereby obtaining frequency parameters $f_m'$ and $\varphi_m'$ using Formulae (10) and (11) below.

[Mathematical Formula 10]

$$f_{m+1}' \leftarrow f_m' - \mu_m \frac{\partial F}{\partial f} \qquad \cdots (1\,0)$$

[Mathematical Formula 11]

$$\phi_{m+1}' \leftarrow \phi_m' - \mu_m \frac{\partial F}{\partial \phi} \qquad \cdots (1\,1)$$

Incidentally, Formulae (10) and (11) above are abbreviated as Formula (12) below. In addition, $\mu_m$ denotes a weighting factor based on a so-called deceleration method and takes a value of 0 to 1 at a timely basis in order to convert a cost function obtained by each recurrence equation into a monotonically decreasing sequence.

[Mathematical Formula 12]

$$\partial F = \partial F(A_m', f_m', \phi_m') \qquad \cdots (1\,2)$$

When it has been possible to obtain the frequency parameters $f_m'$ and $\varphi_m'$, since the frequency parameter $A'$ as a coefficient of the sinusoidal model signal in Formula (4) above can uniquely be obtained, a frequency parameter $A_m'$ is subjected to convergence in the present frequency analysis technique using Formula (13) below.

[Mathematical Formula 13]

$$A_{m+1}' \leftarrow A_m' - \mu_m \frac{\partial F}{\partial \phi} \qquad \cdots (1\,3)$$

The series of calculations are repeatedly made in the present frequency analysis technique to enable the amplitude $A'$, frequency $f'$ and initial phase $\varphi'$ to be converged with high precision. In particular, the frequency parameters $f'$ and $\varphi'$ constituting the phase of the sinusoidal model signal in Formula (4) above and the frequency parameter $A'$ as the coefficient are obtained separately in the present frequency analysis technique, thereby enabling the calculations to be easily made.

However, though the convergence is established from a relatively wide range, one repetition results in low accuracy and much time is required until the convergence.

In the present frequency analysis technique, therefore, it is desirable that the steepest descent method is applied to converge the frequency parameters $f_m'$ and $\varphi_m'$ to some extent and thereafter the so-called Newton method is applied to establish the convergence with high precision. To be specific, in the present frequency analysis technique, the recurrence formulae shown in Formulae (14) and (15) are used as the Newton method to obtain the frequency parameters $f_m'$ and $\varphi_m'$.

### [Mathematical Formula 14]

$$f_{m+1}' = f_m' - \frac{v_m}{J}\begin{vmatrix}\dfrac{\partial F}{\partial f} & \dfrac{\partial^2 F}{\partial f \partial \phi}\\[2ex] \dfrac{\partial F}{\partial \phi} & \dfrac{\partial^2 F}{\partial \phi^2}\end{vmatrix} \qquad \cdots (1\ 4)$$

### [Mathematical Formula 15]

$$\phi_{m+1}' = \phi_m' - \frac{v_m}{J}\begin{vmatrix}\dfrac{\partial^2 F}{\partial f^2} & \dfrac{\partial F}{\partial f}\\[2ex] \dfrac{\partial^2 F}{\partial f \partial \phi} & \dfrac{\partial F}{\partial \phi}\end{vmatrix} \qquad \cdots (1\ 5)$$

It is noted, however, that in Formulae (14) and (15) above, J is expressed in Formula (16) below, abbreviated by Formula (17) below. In addition, $v_m$ denotes a weighting coefficient based on the deceleration method similarly to $\mu_m$ and takes a value of 0 to 1 at a timely basis.

### [Mathematical Formula 16]

$$J = \begin{vmatrix}\dfrac{\partial^2 F}{\partial f^2} & \dfrac{\partial^2 F}{\partial f \partial \phi}\\[2ex] \dfrac{\partial^2 F}{\partial f \partial \phi} & \dfrac{\partial^2 F}{\partial \phi^2}\end{vmatrix} \qquad \cdots (1\ 6)$$

### [Mathematical Formula 17]

$$\partial^2 F = \partial^2 F(A_m', f_m', \phi_m') \qquad \cdots (1\ 7)$$

In the present frequency analysis technique, the frequency parameters $f_m'$ and $\varphi_m'$ are obtained from Formulae (14) and (15) above, then the frequency parameter $A_m'$ is converged using Formula (13) above similarly to the steepest descent method and the series of calculations are further repeated.

Thus, in the present frequency analysis technique, a hybrid solution method combining the steepest descent method and Newton method is used to enable the frequency parameters $A'$, $f$ and $\varphi'$ to be estimated at high speed with high precision.

In addition, in the present frequency analysis technique, even in the case where the analysis object signal x (n) comprises a composite sinusoidal wave, its is possible to lead approximately to a spectral parameter through successive subtraction processing. In this case, it is assumed that the analysis object signal x(n) is the sum of plural sinusoidal waves and is expresed as Formula (18) below.

## [Mathematical Formula 18]

$$x(n) = \sum_{k=1}^{N} A_k \cos(2\pi f_k \frac{n}{f_s} + \phi_k) \qquad \cdots (18)$$

In the case where the frequency $f_k$ of the analysis object signal x(n) is not in agreement with the frequency parameter f' of the sinusoidal model signal from the Parseval's theorem, i.e. in the case of Formula (19) below, the nonlinear equation shown by Formula (4) above becomes Formula (20) below. In addition, in the case where the pair of frequency parameters f' and φ' is in agreement with either the frequency $f_k$ or the initial phase $\varphi_k$, the nonlinear equation shown by Formula (4) above becomes Formula (21) below. Furthermore, when the amplitude $A_j$ has been in agreement with the frequency parameter A', the frequency components on the estimated spectra can completely be purged from the analysis object signal. For this reason, the problem of seeking optimal solutions is independent of the frequency and, when the solutions are separately estimated successively from the analysis object signal, the problem can be applied to a signal expressed by plural sinusoidal waves.

## [Mathematical Formula 19]

$$f_k \neq f' \qquad \cdots (19)$$

## [Mathematical Formula 20]

$$F(A', f', \phi') = A'^2 + \sum_{k=1}^{N} A_k^2 \qquad \cdots (20)$$

## [Mathematical Formula 21

$$F(A', f', \phi') = (A_j - A')^2 + \sum_{k=1 k \neq j}^{N} A_k^2 \qquad \cdots (21)$$

That is to say, in the present frequency analysis technique, even in the case where the analysis object signal x(n) comprises the composite sinusoidal wave, the similar processing is performed relative to a successive residual error signal to enable plural sinusoidal waves to be extracted.

It is noted, however, that in the case of plural spectra, since an indefinite length is presupposed as is clear from Formula (3) above, the period of a synthetic spectrum is much larger than the analysis window length in the case where the frequencies of plural spectra are near one another to fail to satisfy Formula (17) above and, therefore, some errors may be observed.

In order to express an audio or acoustic signal as a composite sinusoidal wave, a great number of spectra (the number of sinusoidal waves) have heretofore been required. In the present frequency analysis technique, however, even in such a signal, a small number of spectra can express it without error. That is to say, it goes without saying that the fact of enabling a signal to be expressed by means of a smaller number of spectra is effective for the application of data compression and, besides, indicates that essential characteristics of the signal can be detected by using the aforementioned fact as an approach to the wave number expression on a physical phenomenon. Thus, the present frequency analysis technique is effective also for an analysis object signal of a composite sinusoidal wave and applicable to various kinds of fields.

[Effectiveness of Present Frequency Analysis Technique]

The effectiveness of the present frequency analysis technique will be described hereinafter in detail.

Conventionally, in order to analyze a signal measured with a sensor using a computer, part of the signal has been cut out and analyzed by means of the DFT that is a typical harmonic frequency analysis technique.

However, subjecting the analysis object signal to cutout (windowing) amounts to nothing other than an analysis, with the partial cutout signal as a fiction regarded as a signal repeated in a strict period. It is a matter of course that the frequency characteristics thereof do not become in complete agreement with the original spectral characteristics. In addition, in order to avoid the influence of the signal cutout, though attempts have been made to alleviate the influence using a window function, no change exists in analyzing the partial cutout signal in a strict period and, therefore, it is as the case now stands that the problem does not reach an essential solution.

In contrast, the present frequency analysis technique performs formulation with the aim of a frequency analysis having assumed a nonperiodic signal and, therefore, it is possible to accurately estimate a frequency and its parameters without being subjected to restraints of the analysis window length and frequency resolution.

In addition, since frequency estimation is changed from the conventional discrete search to a dynamic and continuous search, the present frequency analysis technique is an innovative technique capable of enhancing the precision dramatically. Particularly, since the present frequency analysis technique can estimate accurate characteristics through observation and analysis of part of a phenomenon when a system is kept stable, it can be expected to be applicable to a prediction problem.

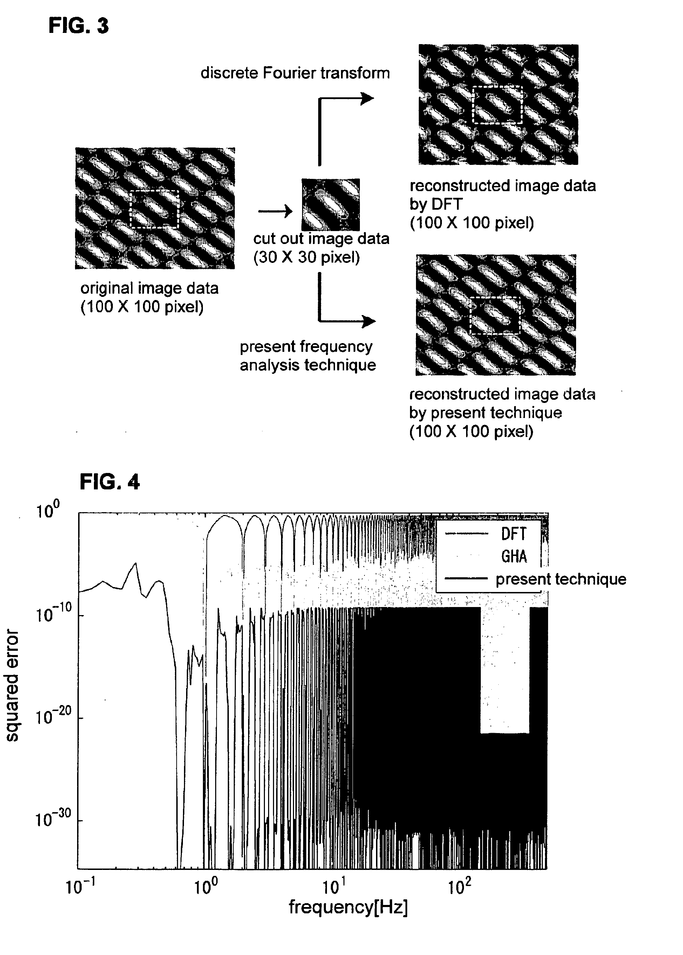

Furthermore, as regards multidimensionality, the conventional frequency analysis technique is affected by the window function similarly to the case where an analysis object signal is one-dimensional. To be specific, as shown in Figure 3, for example, even when a portion of a two-dimensional analysis object signal (original image data) surrounded by a broken line in the left figure of Figure 3 has been cut out and subjected to the DFT to analyze the same, the analysis is equivalent to the fact that an endlessly repeated image with the cut-out interval as a strict period has been analyzed. As shown in the upper right figure, therefore, a restored image data has been affected by the window function, thereby making it difficult to find out essential characteristics.

In contrast, in the present frequency analysis technique having adopted Formula (6) above, as shown in the lower right figure of Figure 3, the influence of the window function is alleviated to find out the essential frequency characteristics, thereby enabling the surrounding image of the cut-out terminal to be completely reconstructed.

As described above, the present frequency analysis technique can obtain the frequency $f$, amplitude $A'$ and initial phase $\varphi'$ of the sinusoidal model signal at high speed with high precision through seeking an optimal solution to the nonlinear equation. To demonstrate concrete accuracy, the present inventor verified the accuracy, with the DFT and GHA (Generalized Harmonic Analysis) that is said to have the highest analysis accuracy among developed DFTs to be compared and contrasted.

Incidentally, since the DFT or GHA allows a single analysis window length to apparently have plural window lengths, though the frequency resolution depends on the analysis window length, the resolved frequency thereof has a finite length and cannot be analyzed in the case where the frequency of the analysis object signal has become a frequency other than the resolved frequency and, in the case where the analysis object signal has a frequency different from the frequencies capable of being accurately analyzed, the surrounding frequencies (sideband wave components) of small spectra appear in addition to nearest resolved frequency to allow plural frequencies to emerge.

In order to verify whether or not such a phenomenon occurs in the present frequency analysis technique, i.e. the frequency resolution of the present frequency analysis technique, a single, one-dimensional, very short sinusoidal wave with an analysis window length of one sec. (1024 samples) was analyzed, one sinusoidal wave was extracted by each technique, and a squared error between the extracted wave and the original signal was examined. The results thereof are shown in Figure 4.

As shown in Figure 4, analysis accuracy deterioration at a frequency other than an integral multiple of the basic frequency was found in the DFT, and accuracy enhancement of number of around 2 to 5 figures as compared with the case of the DFT at a frequency of 1 Hz or more was found in the GHA. In contrast, in the present frequency analysis technique, accuracy enhancement of number of 10 figures or more as compared with the case of the DFT and of number of 5 figures or more as compared with the case of the GHA at a frequency of 1 Hz or more was found. That is to say, the present frequency analysis technique exhibited accuracy enhancement hundred thousand times or more to ten billion times or more the existing frequency analysis techniques.

Particularly, to enable the frequency of 1 Hz or less to be accurately estimated indicates that even a signal having a long period exceeding the analysis widow length can be analyzed and that a spectral structure of a signal containing various fluctuation factors, such as a stock price, can be estimated more accurately.

Thus, the present frequency analysis technique can make an analysis with considerably high precision even in comparison with the GHA that is said to exhibit the highest analysis accuracy. This technology capable of analyzing a signal with such a high degree of accuracy cannot be found from the domestic and international various study cases and can be said to be a technology expected to be applicable to various fields requiring accurate analysis from now on.

[Concrete Application of Present Frequency Analysis Technique]

Though the frequency analysis has at present been utilized in various fields, it is conceivable that the spillover effects of the present frequency analysis technique can be expected over other fields than the aforementioned various fields. Since the present frequency analysis technique can obtain Fourier coefficient parameters with high precision without use of the Fourier transform, there is a probability of phenomena thought heretofore as various unsteady fluctuations other than acousmato and vibration involving periodicity (wave nature) being modeled as signals involving the periodicity. Applications of the present frequency analysis technique made by the present inventor will be described hereinafter.

[Application to Measurement Field]

In recent years, it has been made clear that when a piano string has been hammered, the piano string is added with horizontal vibration in addition to vertical vibration to make rotary motion on an elliptic orbit from the steps of setting laser measurement equipment in the vicinity of the piano string and measuring a distance displacement between the equipment and the piano string. Also, in recent years, it has been optically verified that a single piano string has two basic frequencies and shows continuous changes while being alternately shaken with these basic frequencies.

However, it is difficult to accurately perceive small shakiness at the frequencies of the piano string by measuring the sound of a piano and analyzing the frequency of the sound. In most cases, the conventional analyses have been made using a spectrum analyzer represented by the DFT or fast Fourier transform (FFT). Generally, however, it has been impossible to analyze small shakiness of the piano string owing to the influence of the window function or low frequency resolution. Therefore, there is no report on a best practice of analyzing a sound along equivalent to that of optical measurement.

In view of the above, the present inventor has used the present frequency analysis technique to make attempts to estimate spectral characteristics of a piano string and visualize shakiness around the spectrum only from an observed sound of acoustic quality substantially corresponding to that of a CD (Compact Disc) generally used.

To be specific, as shown in Figure 4, a signal having the sound of a piano having a letter notation A4 (la, 440 Hz) recorded at a sampling frequency of 44.1 kHz that was the same as that of a CD was used as an analysis object signal, and the analysis object signal was analyzed with each of the DFT and the present frequency analysis technique, thereby evaluating the spectrogram thereof. The analysis interval was 1 sec., the window length had 4096 points (0.093 millisecond), and the shift length was set to be 1/16 of the window length. When the window length was used, the frequency resolution width of the DFT was about 10.76 Hz.

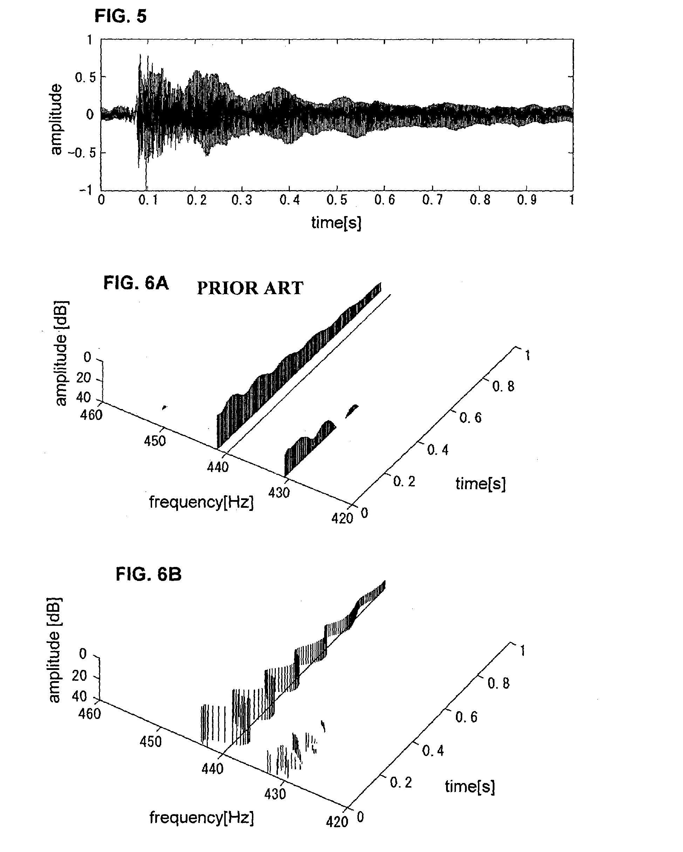

The analysis results are shown in Figures 6(A) and 6(B). Figure 6(A) shows the analysis results by the DFT and is an enlarged view of the neighborhood of a ground note. In addition, Figure 6(B) shows the analysis results by the present frequency analysis technique and is also an enlarged view of the neighborhood of the ground note. Incidentally, in Figures 6(A) and 6(B), the right-side abscissa axis stands for a time, the left-side abscissa axis for a frequency and the axis of ordinate for amplitude.

Figure 6(A) shows a spectrum at the aforementioned frequency resolution width of about 10.76 Hz. Since the spectrum emerging in the vicinity of 440 Hz is largest in Figure 6(A), it can be understood that a correct spectrum exists in the vicinity thereof. In addition, a spectrum assuming increase and decrease of energy as undulated in the vicinity of 430 Hz can be confirmed. Since an external force does not act subsequent to keying at the time of tuning this time, it cannot be thought that the increase and decrease of energy occurs. Thus, since it can be anticipated that the frequency around the spectrum in the vicinity of 440 Hz shakes. However, it is impossible to analyze small fluctuation of the frequency analysis width or less to make it impossible to exactly grasp what kind of phenomenon occurs.

In contrast, it can clearly be grasped from Figure 6(B) that spectra emerging around 440 Hz are being continuously shaken. This is nothing more or less than the fact that the frequency variation is perceived owing to the piano string makes rotary motion on plural elliptical orbits, and the frequency shakiness of the frequency that has been unable to be perceived by the DFT can be confirmed. In addition, it can be understood that the present frequency analysis technique accurately estimates the frequency (440 Hz) as compared with the DFT even when the analysis window lengths are the same as each other.

Thus, though the phenomenon in which the frequency shakiness exists due to the influence of the window length cannot be expressed by a spectral monotone decreasing function in the DFT, it can be expressed in the present frequency analysis technique by a monotone decreasing spectrum involving frequency fluctuation. For this reason, the present frequency analysis technique is effective for analyzing the monotonically decreasing spectrum involving complicated frequency fluctuation.

As is clear from the experiment, it can be said that the present frequency analysis technique is a breakthrough technique capable of yielding results of the analysis of the sound of CD acoustic quality equivalent to results of the optical measurement.

[Coding of Image]

Since the influence of the window is small in the present frequency analysis technique, no sideband component emerges in a spectrum. That is to say, as described above, the present frequency analysis technique can efficiently express even a complicated analysis object signal as a small number of spectra without error.

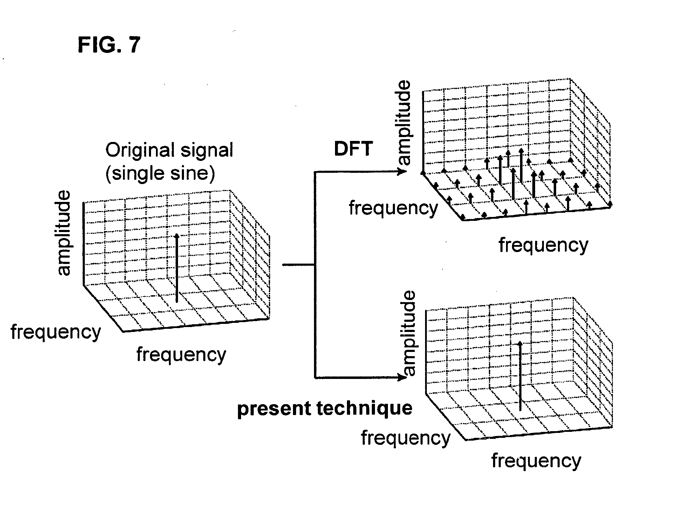

Figure 7 shows concrete examples in which two-dimensional signals are analyzed with the DFT and the present frequency analysis technique, respectively. As shown in the left figure of Figure 7, in the case where a signal normally expressed by a single spectrum has been transformed with the DFT, in the spectrum generally obtained by the transform plural sideband components emerge in a group as shown in the upper right figure of Figure 7 resulting from the influence of the analysis window as shown in the lower right figure of Figure 3. This is the same in the discrete cosine transform (DCT) widely used in compression coding of images. In contrast, the present frequency analysis technique can accurately estimate the spectrum of the original signal as shown in the lower right figure of Figure 7. The accurate analysis has a probability of the number of spectra expressing image data being dramatically reduced and can expect significant data compression effects without degrading the image quality.

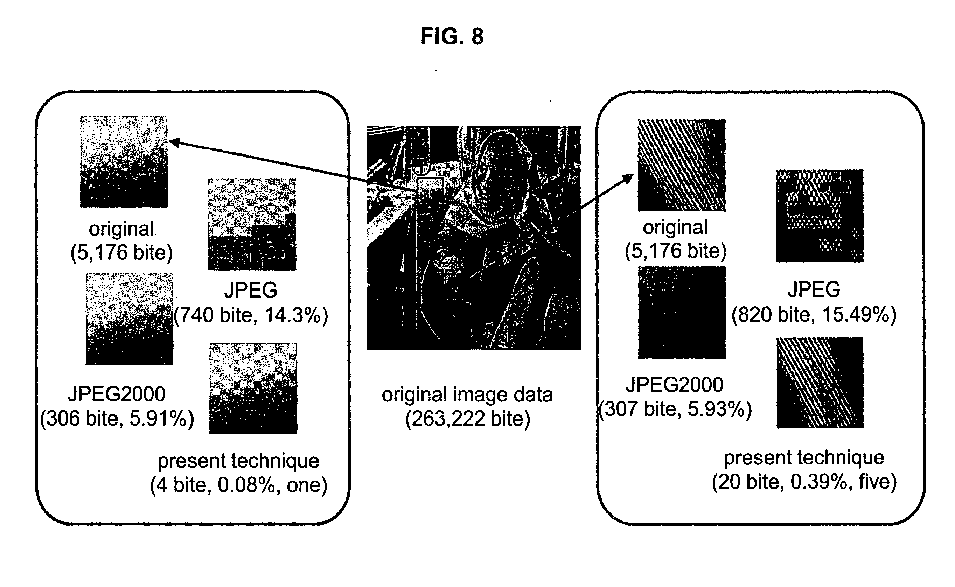

A two-dimensional bitmap image data shown in the central figure of Figure 8 was software-compressed, with the JPEG (Joint Photographic Experts Group) and JPEG2000, which were in fact known widely as a general technique for image compression, compared and contrasted. Incidentally, it is universally known that the JPEG is a technique utilizing the DCT as the basic analysis and that the JEG2000 is a technique utilizing the wavelet transform as the basic analysis.

After compressing the image data shown in the central figure of Figure 8 utilizing each frequency analysis technique, the results of cutting out the background portions photographed in the image data are shown in the left figure of Figure 8, and the results of cutting out clothes portions of the person photographed in the image data are shown in the right figure of Figure 8. That is to say, the results shown in the left figure of Figure 8 are compression results of the loosely changed partial images (low-frequency signals), and the results shown in the right figure of Figure 8 are compression results of the severely changed partial images (high-frequency signals).

It could be understood from the left figure of Figure 8 that in consequence of compressing the original portion image of 5176 bytes, in the JPEG the compressed image had 740 bytes that had the size of 14.3% of the original portion image size and that in the JPEG2000 the compressed image had 306 bytes that had the size of 5.91% of the original portion image size. In contrast, in the present frequency analysis technique, the compressed image had 4 bytes that had the size of 0.08% of the original portion image size. Incidentally, the number of spectra required for restoring the original portion image from the image compressed by the present frequency analysis technique was one only.

On the other hand, it could be understood from the right figure of Figure 8 that in consequence of compressing the original portion image of 5176 bytes, in the JPEG the compressed image had 820 bytes that had the size of 15.49% of the original portion image size and that in the JPEG2000 the compressed image had 307 bytes that had the size of 5.93% of the original portion image size. In contrast, in the present frequency analysis technique, the compressed image had 20 bytes that had the size of 0.39% of the original portion image size. Incidentally, the number of spectra required for restoring the original portion image from the image compressed by the present frequency analysis technique was five.

Thus, the amount of the compressed data in the present frequency analysis technique becomes 1/100 to 1/10 of those in the general technique, such as the JPEG or JPEG2000 and, therefore, the data compression ratio far surpassing those of others can be realized. In addition, the present frequency analysis technique is also a technique capable of specifying the characteristics of a wide range of signals from low-frequency signals to high-frequency signals with high accuracy. Particularly, in the case where loosely changed signals are to be analyzed in the present frequency analysis technique, since it is possible to specify the period over the analysis window, an image of the background etc. can efficiently be coded. Therefore, by applying the present frequency analysis technique to the television broadcasting service transferred to digital broadcasting, the present frequency analysis technique has a probability that the quality of an image equivalent to or more than that of high resolution digital broadcasting, which is even so-called one-segment broadcasting utilizing a mobile computer, is provided. Thus, it is extremely significant that the present frequency analysis technique can become a core technology in the next-generation image/dynamic picture image coding technology.

[Prediction of Economical Time Series]

When air pressure changes at a point in a space under the circumstances under which an action capable of keeping an equilibrium state of atmospheric pressure exists, such pressure change involving wave nature propagates the surroundings. This phenomenon can be thought to be a wave phenomenon when the aforementioned pressure has been substituted with pressure in sale and purchase of commodities and when it is presupposed that an action of keeping economical indicators in an equilibrium state is exerted. When being based on this thinking, a periodic fluctuation factor can be presupposed relative to the economical time series represented by stock prices and, in fact, studies focusing on the periodicity of the economic time series accompanied with the Elliott wave have been made.

However, It is thought that the periodicity of the economical time series is expressed by means of a model having various composite periodicities combined. Furthermore, in an actual market, each of the periodicities constitutes a complicated model fluctuated temporally.

Therefore, the present inventor tried to apply the present frequency analysis technique to such a difficult problem. Particularly, since the present frequency analysis technique exhibits small dependency on the analysis window and high frequency resolution, it is possible to easily perform long-term prediction having a convention property.

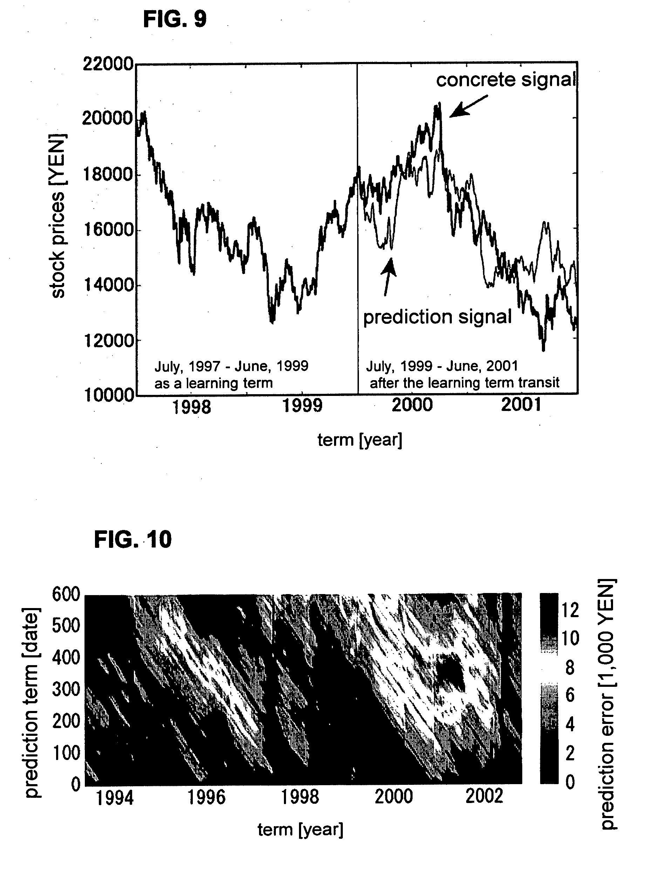

The actual transit of the closing prices in the Nikkei Stock Average during the last four years (from July, 1997 to June, 2001) is shown using a bold solid line in Figure 9. The present frequency analysis technique was used, with the last two years (from July, 1997 to June, 1999) as a learning term and the data during the learning term of the stock price data as an analysis object signal. Then, it was estimated how the stock prices during two years (from July, 1999 to June, 2001) after the learning term transit. To be specific, by using the present frequency analysis technique, with the stock price data during the last two-year learning term as the analysis object signals, obtaining the frequency, amplitude and initial phase determining plural sinusoidal waves and extension-depicting the data during the two years thereafter, with these parameters determined as being unchanged provisionally, prediction data were obtained. The results thereof are shown using a thin solid line in Figure 9. It can be confirmed from Figure 9 that the long-last up-and-down fluctuations are perceived substantially accurately without being affected by an analysis window.

In addition, in order to estimate a predictable period of the present frequency analysis technique, data during the interval of about 11 years having eliminating the date during the initial two years as the learning term and the data during the termination two years for evaluation were extracted from the actual data of the closing prices in the Nikkei Stock Average during the term of about 15 years from January 4, 1997 to August 11, 2005 and used to verify prediction results. To be specific, the present frequency analysis technique was used to obtain prediction data similarly to the case of Figure 9, with the analysis term made constant and the date moved day by day from February 1, 1993 to July 9, 2003, and to obtain distribution in error between the actual stock price data and the prediction data for two years after each of the times at which the data were obtained for last two years. The results thereof are shown in Figure 10.

It can be seen from Figure 10 that many regions each having the prediction error of 10% or less exist. Incidentally, why the errors in the terms in the vicinity of 1997 and 2001 became large was that it was conceivable that the Asian currency crisis generated in July, 1997 in the former term and the series of terrorist attacks generated in September, 2001 in the latter term affected the stock prices to make it impossible to maintain the inertial fluctuations. Though errors tend to be large immediately after the sudden fluctuations in consequence of the generation of such serious affairs, it can be confirmed that the errors thereafter become small. This is why it is conceivable that since the analysis term is set to be two years, accurate periodicity is reflected on prediction results by the time the periodicity has become stable again without suffering from the periodicity before the generation of the affairs in the prediction up to elapse of some time from the generation of the affairs. It was found from the above that the present frequency analysis technique accurately estimated the configuration of spectra during an analysis term of around two years and could suppress the prediction errors to a small number even in the case where subsequent two-year fluctuations were predicted for a long period of time at that time insofar as no unpredictable affair is generated.

Thus, since the present frequency analysis technique has very high frequency resolution, it has a probability that the characteristics of a signal can essentially be detected through the analysis of a partial term. Conventionally, in this field, various methods have been tried, such as a phenomenon modeling represented by a so-called random walk, a genetic algorithm (GA), a neural network or an artificial intelligence approach represented by an agent approach. However, there has been no report on such a long-term prediction. As is understood from this fact, it can be said that the present frequency analysis technique has high analysis accuracy greatly outstripping other techniques and can be applied to the fields of application to economical numbers including middle-period and long-period prediction of stock prices, prediction of influence of economical numbers in financial policy, investment planning, policy conclusion and various risk managements.

[Effects of Present Frequency Analysis Technique]

As has been described in the foregoing, the present frequency analysis technique can realize extremely high signal analysis accuracy through the acquisition of an optimal solution to a nonlinear equation without causing frequency resolution to depend on an analysis window length. Since the present frequency analysis technique relates to an elementary technology in various engineering fields, the utility value thereof is extremely high. Since the present frequency analysis technique has high frequency resolution, for example, by applying the present technique to application fields on which the harmonic frequency analysis represented by the DFT has had limitations, not to mention the existing fields requiring the frequency analysis, there is a strong chance of enabling analysis effects to be improved to a great extent.

In addition, since the present frequency analysis technique does not depend on the analysis window, it is possible to grasp, through partial observation of a continuously fluctuating signal, the characteristics of the overall signal, thereby enabling application to prediction problems.

Incidentally, the present invention is not limited to the aforementioned embodiment. In the embodiment described above, for example, the description has been made the signal analysis device is used to analyze the frequency with software. However, the present invention can realize the same with hardware using a DSP (Digital Signal Processor) having the algorithm of the present frequency analysis technique mounted therein insofar as it can perform the product-sum operation.

Thus, it goes without saying that the present invention can appropriately be modified in a range not departing from the gist thereof.

**Claims**

1. A signal analysis method being for analyzing the frequency of a signal to be input and comprising:

a signal-inputting step of inputting into a signal analysis device an analysis object signal to be analyzed and storing the input signal in a memory;

a parameter-calculating step of retrieving with calculation means of the signal analysis device the analysis object signal input and stored in the memory at the signal-inputting step and obtaining a frequency f', amplitude A' and an initial phase φ' such that a sum of squares of a difference between the analysis object signal and a sinusoidal model signal expressed by a phase using the frequency f' and the initial phase φ' and by the amplitude A' is a minimum value; and

an analysis result-outputting step of outputting to analysis result-outputting means analysis results based on the frequency f', amplitude A' and initial phase φ' obtained at the parameter-calculating step.

2. A signal analysis method according to claim 1, wherein the calculation means at the parameter-calculating step calculates:

a frequency $f_x'$, the amplitude $A'$ and the initial phase φ' such that a right-hand side of general Formula (1) below becomes a minimum value when the frequency object signal is a one-dimensional analysis signal $s(x_n)$;

frequencies $f_x'$ and $f_y'$, the amplitude $A'$ and the initial phase φ' such that a right-hand side of general Formula (2) below becomes a minimum value when the frequency object signal is a two-dimensional analysis signal $s(x_m, y_n)$;

frequencies $f_x'$, $f_y'$ and $f_z'$, the amplitude $A'$ and the initial phase φ' such that a right-hand side of general Formula (3) below becomes a minimum value when the frequency object signal is a three-dimensional analysis signal $s(x_l, y_m, z_n)$;

frequencies $f_x'$, $f_y'$, $f_z'$ and $f_w'$, the amplitude $A'$ and the initial phase φ' such that a right-hand side of general Formula (4) below becomes a minimum value when the frequency object signal is a four-dimensional analysis signal $s(x_k, y_l, Z_m, w_n)$; and

frequencies $f_{x1}'$, $f_{x2}'$, $f_{x3}'$, ...and $f_{xn}$, the amplitude $A'$ and the initial phase φ' such that a right-hand side of general Formula (5) below becomes a minimum value when the frequency object signal is a n-dimensional analysis signal $s(x1_{n1}, x2_{n2}, x3_{n3}, ...xn_{nn})$.

## [Mathematical Formula 1]

$$F(A', f_x', \phi') = \frac{1}{N} \sum_{n=1}^{N} \left\{ s(x_n) - A'\cos(2\pi f_x' x_n + \phi') \right\}^2 \qquad \cdots (1)$$

## [Mathematical Formula 2]

$$F(A', f_x', f_y', \phi') = \frac{1}{MN} \sum_{m=1}^{M} \sum_{n=1}^{N} \left\{ s(x_m, y_n) - A' \cos(2\pi f_x' x_m + 2\pi f_y' y_n + \phi') \right\}^2$$

$$\cdots (2)$$

## [Mathematical Formula 3]

$$F(A', f_x', f_y', f_z', \phi') = \frac{1}{LMN} \sum_{l=1}^{L} \sum_{m=1}^{M} \sum_{n=1}^{N} \left\{ s(x_l, y_m, z_n) - A' \cos(2\pi f_x' x_l + 2\pi f_y' y_m + 2\pi f_z' z_n + \phi') \right\}^2$$

$$\cdots (3)$$

## [Mathematical Formula 4]

$$F(A', f_x', f_y', f_z', f_w', \phi')$$

$$= \frac{1}{KLMN} \sum_{k=0}^{K-1} \sum_{l=0}^{L-1} \sum_{m=0}^{M-1} \sum_{n=0}^{N-1} \left\{ s(x_k, y_l, z_m, w_n) - A' \cos(2\pi f_x' x_k + 2\pi f_y' y_l + 2\pi f_z' z_m + 2\pi f_w' w_n + \phi') \right\}^2$$

$$\cdots (4)$$

## [Mathematical Formula 5]

$$F(A', f_{x1}', f_{x2}', f_{x3}', \cdots, f_{xn}', \phi')$$

$$= \frac{1}{N1 \cdot N2 \cdot N3 \cdots \cdot NN}$$

$$\sum_{n1=0}^{N1-1} \sum_{n2=0}^{N2-1} \sum_{n3=0}^{N3-1} \cdots \sum_{nn=0}^{NN-1} \left\{ s(x1_{n1}, x2_{n2}, x3_{n3}, \cdots, xn_{nn}) - A' \cos(2\pi f_{x1}' x1_{n1} + 2\pi f_{x2}' x2_{n2} + 2\pi f_{x3}' x3_{n3} + \cdots + 2\pi f_{xn}' xn_{nn} + \phi') \right\}$$

$$\cdots (5)$$

3. A signal analysis method according to claim 1, wherein the calculation means at the parameter-calculating step calculates appropriate initial values of the frequency f, the amplitude A' and the initial phase φ', respectively, and converges the initial values calculated into optimal solutions to a nonlinear equation, thereby calculating the frequency f, the amplitude A' and the initial phase φ'.

4. A signal analysis method according to claim 3, wherein the parameter-calculating step comprises:

a first calculating step in which the calculation means subjects the frequency f and the initial phase φ' constituting a phase of the sinusoidal model signal to convergence using a steepest descent method to obtain the frequency f and the initial phase φ'; and
a second calculating step in which the calculating means subjects the amplitude A' that is a coefficient of the sinusoidal model signal to convergence using the steepest descent method after obtaining the frequency f' and the initial phase φ' at the first calculating step to obtain the amplitude A'.

5. A signal analysis method according to claim 4, wherein the calculating means at the first calculating step subjects the frequency f and the initial phase φ' to convergence using the steepest descent method and the frequency f and the initial phase φ' to convergence using the Newton method.

6. A signal analysis device being for analyzing the frequency of a signal to be input and comprising

signal-inputting means for inputting an analysis object signal to be analyzed, parameter-calculating means for obtaining a frequency $f$, amplitude $A'$ and an initial phase $\varphi'$ such that a sum of squares of a difference between the analysis object signal input via the signal-inputting means and a sinusoidal model signal expressed by a phase using the frequency $f$ and the initial phase $\varphi'$ and by the amplitude $A'$ is a minimum value, and analysis result-outputting means for outputting analysis results based on the frequency $f$, amplitude $A'$ and initial phase $\varphi'$ obtained with the parameter-calculating means.

7. A signal analysis program being for executing a computer for analyzing the frequency of a signal to be input and allowing the computer to function:

as signal-inputting means for inputting an analysis object signal to be analyzed,
as parameter-calculating means for obtaining a frequency $f$, amplitude $A'$ and an initial phase $\varphi'$ such that a sum of squares of a difference between the analysis object signal input via the signal-inputting means and a sinusoidal model signal expressed by a phase using the frequency $f$ and the initial phase $\varphi'$ and by the amplitude $A'$ is a minimum value; and
as analysis result-outputting means for outputting analysis results based on the frequency $f$, amplitude $A'$ and initial phase $\varphi'$ obtained with the parameter-calculating means.

FIG. 1

**FIG. 2**

Signal to be analyzed

frequency

time

discrete Fourier transform

windowing

frequency

time

time

frequency

time

time

signal analysis method

present frequency analysis technique

continuous

Transient spectrum

frequency

time

EP 2 192 415 A1

## FIG. 3

discrete Fourier transform

original image data
(100 X 100 pixel)

cut out image data
(30 X 30 pixel)

present frequency
analysis technique

reconstructed image data
by DFT
(100 X 100 pixel)

reconstructed image data
by present technique
(100 X 100 pixel)

## FIG. 4

FIG. 5

FIG. 6A    PRIOR ART

FIG. 6B

**FIG. 7**

Original signal
(single sine)

DFT

present technique

## FIG. 8

original
(5,176 bite)

JPEG
(740 bite, 14.3%)

JPEG2000
(306 bite, 5.91%)

present technique
(4 bite, 0.08%, one)

original image data
(263,222 bite)

original
(5,176 bite)

JPEG
(820 bite, 15.49%)

JPEG2000
(307 bite, 5.93%)

present technique
(20 bite, 0.39%, five)

EP 2 192 415 A1

## FIG. 9

Graph: stock prices [YEN] vs term [year]

Y-axis: 22000, 20000, 18000, 16000, 14000, 12000, 10000

X-axis: 1998, 1999, 2000, 2001

concrete signal

prediction signal

July, 1997 - June, 1999 as a learning term

July, 1999 - June, 2001 after the learning term transit

## FIG. 10

Y-axis (prediction term [date]): 600, 500, 400, 300, 200, 100, 0

X-axis (term [year]): 1994, 1996, 1998, 2000, 2002

Colorbar (prediction error [1,000 YEN]): 12, 10, 8, 6, 4, 2, 0

| **INTERNATIONAL SEARCH REPORT** | International application No. |
|---|---|
| | PCT/JP2008/066689 |

**A. CLASSIFICATION OF SUBJECT MATTER**
*G01R23/16(2006.01)i, G01R23/00(2006.01)i, G06F17/14(2006.01)i*

According to International Patent Classification (IPC) or to both national classification and IPC

**B. FIELDS SEARCHED**

Minimum documentation searched (classification system followed by classification symbols)
G01R23/00-23/20, G06F17/14, G10L11/00-13/08, G10L19/00-21/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
CiNii

**C. DOCUMENTS CONSIDERED TO BE RELEVANT**

| Category* | Citation of document, with indication, where appropriate, of the relevant passages | Relevant to claim No. |
|---|---|---|
| Y<br>A | WO 2006/010002 A2 (FLORIDA ATLANTIC UNIVERSITY),<br>26 January, 2006 (26.01.06),<br>Column 8, line 1 to column 19, line 11;<br>Figs. 4 to 6B<br>& JP 2008-508542 A<br>Par. Nos. [0013] to [0047]; Figs. 4 to 6B<br>& US 2005/283360 A1    & EP 1774514 A2 | 1,3,4,6,7<br>2,5 |
| Y<br>A | Shigeki HIROBAYASHI, Yohei SHIBANO, Tatsuo YAMABUCHI, "Improvement of the Spectral Subtraction Method by High-resolution Frequency Analysis", IEEJ Transaction C on Electronics, Information and Systems, 01 January, 2005 (01.01.05), Vol.125, No.1, pages 147 to 148 | 1,3,4,6,7<br>2,5 |

☒ Further documents are listed in the continuation of Box C.　　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 November, 2008 (28.11.08) | 09 December, 2008 (09.12.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

EP 2 192 415 A1

**INTERNATIONAL SEARCH REPORT**

International application No.

PCT/JP2008/066689

C (Continuation). DOCUMENTS CONSIDERED TO BE RELEVANT

| Category* | Citation of document, with indication, where appropriate, of the relevant passages | Relevant to claim No. |
|---|---|---|
| A | Mikio TOYAMA, Tsunehiko KOIKE, "High resolution frequency analysis", Journal of the Acoustical Society of Japan, 01 August, 1998 (01.08.98), Vol.54, No.8, pages 568 to 574 | 1-7 |
| A | JP 2001-116780 A (Yamaha Corp.), 27 April, 2001 (27.04.01), Par. Nos. [0015] to [0040]; Figs. 1 to 7 (Family: none) | 1-7 |
| A | JP 2003-227854 A (Mitsubishi Electric Corp.), 15 August, 2003 (15.08.03), Par. Nos. [0015] to [0064]; Figs. 1 to 14 (Family: none) | 1-7 |

Form PCT/ISA/210 (continuation of second sheet) (April 2007)

26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Mikio Tohyama ; Tsunehiko Koike.** Signal Analysis Means with High Frequency Analysis Accuracy. *Journal of the Acoustical Science of Japan,* 1988, vol. 54 (8
- **L. R. Rabiner ; R. W. Schafer.** Digital Processing of Speech Signals. Prentice-Hall, 1978
- **T. F. Quatieri ; R. J. McAullay.** Speech transformations based on a sinusoidal representation. *IEEE Trans. Acoust. Speech Signal Process,* 1986, vol. 34, 1449-1464

- **E. B. George ; M. J. Smith.** *Analysis-by-synthesis/overlap-add sinusoidal representations'', J. Audio Eng. Soc.,* 1992, vol. 40, 497-515
- **E. B. George ; M. J. Smith.** Speech analysis/synthesis and modification using analysis-by-synthesis/overlap-add sinusoidal model. *IEEE Trans. Speech Audio Process,* 1997, vol. 5, 389-406
- **T. Terada ; H. Nakajima ; M. Tohyama ; Y. Hirata.** Non-stationary wafeform analysis and synthesis using generalized harmonic analysis. *IEEE-SP, Int. Symp. TF/TS Analysis,* 1994, 429-432